Europäisches Patentamt

European Patent Office

Office européen des brevets

(19)

(11) Veröffentlichungsnummer: **0 235 389 B1**

(12) # EUROPÄISCHE PATENTSCHRIFT

(45) Veröffentlichungstag der Patentschrift:
22.11.90

(51) Int. Cl.⁵: **G01R 31/32**

(21) Anmeldenummer: **86117867.1**

(22) Anmeldetag: **22.12.86**

(54) Prüfkreis für die synthetische Prüfung von Hochspannungs-Leistungsschaltern.

(30) Priorität: **29.01.86 CH 334/86**

(43) Veröffentlichungstag der Anmeldung:
**09.09.87 Patentblatt 87/37**

(45) Bekanntmachung des Hinweises auf die Patenterteilung:
**22.11.90 Patentblatt 90/47**

(84) Benannte Vertragsstaaten:
**CH DE IT LI NL**

(56) Entgegenhaltungen:
**CH-A- 325 879
DE-A- 2 656 211
DE-B- 1 158 167**

(73) Patentinhaber: **BBC Brown Boveri AG, Haselstrasse,
CH-5401 Baden(CH)**

(72) Erfinder: **Fröhlich, Klaus, Dr., Baldeggstrasse 11,
CH-5400 Baden(CH)**

## Beschreibung

Die Erfindung betrifft einen Prüfkreis gemäss dem ersten Teil des Anspruchs 1.

Aus dem CIGRE-Report 13-02 aus dem Jahre 1974 von J.Tomiyama u.a. mit dem Titel: "New threecircuit arrangement for synthetic testing of high voltage circuit-breakers under four-parameter transient recovery voltage", ist ein Prüfkreis für die synthetische Prüfung des Ausschaltvermögens von Hochspannungs-Leistungsschaltern bekannt, welcher sich aus einem Hochstromkreis und zwei Hochspannungskreisen zusammensetzt. Ein erster Hilfsschalter und ein Prüfschalter sind im Hochstromkreis in Reihe geschaltet. Ferner ist im Hochstromkreis ein als Stromwandler ausgebildeter Sensor angeordnet, dessen Messignal in einer elektronischen Steuereinheit in zeitgenaue Trigger- bzw. Schaltbefehle umgesetzt wird. Im ersten, parallel zum Prüfschalter liegenden Hochspannungskreis, ist eine Schaltstelle vorgesehen, welche als zweiter Hilfsschalter dient, ferner ein mit Gleichspannung aufgeladener Energiespeicher und eine von der elektronischen Steuereinheit her triggerbare Funkenstrecke. Parallel zur Schaltstelle liegt der zweite Hochspannungskreis mit einer Wechselspannungsquelle.

Bei einer Leistungsabschaltung fliesst zunächst der volle Prüfstrom durch den Hochstromkreis. Unmittelbar vor dem für die Löschung vorgesehenen Nulldurchgang des Prüfstromes wird die Funkenstrecke getriggert und damit der erste Hochspannungskreis auf den Prüfschalter draufgeschaltet. Der Energiespeicher, eine geladene Kondensatorbatterie, liefert einen Schwingstrom, der sich im Prüfschalter dem Prüfstrom überlagert. Der erste Hilfsschalter unterbricht den Prüfstrom im Hochstromkreis und unmittelbar darauf schaltet der Prüfschalter den Schwingstrom ab. Ueber dem Prüfschalter steigt nun die wiederkehrende Spannung an mit einer Anfangssteilheit, die durch im ersten Hochspannungskreis liegende Widerstände, Drosseln und Kondensatoren bestimmt ist. Danach schaltet die Schaltstelle in einem durch die Steuereinheit exakt vorgegebenen Moment den zweiten Hochspannungskreis zum ersten Hochspannungskreis dazu. Die Spannungen in den beiden Hochspannungskreisen überlagern sich und am Prüfschalter steigt die wiederkehrende Spannung weiter an. Nach dem Abklingen der Einschwingvorgänge liefert der zweite Hochspannungskreis allein die netzfrequente Wechselspannung, welche am Prüfschalter anliegt.

Bei diesem Prüfkreis werden an die Schaltstelle grosse Anforderungen bezüglich Zuverlässigkeit und Genauigkeit gestellt, die nur ein teurer, mit einer aufwendigen Steuerung versehener Synchronschalter erfüllen kann. Ferner ist der Platzbedarf für diesen Prüfkreis vergleichsweise gross.

Hier will die Erfindung Abhilfe schaffen. Die Erfindung, wie sie in den Ansprüchen gekennzeichnet ist, löst die Auägabe einen Prüfkreis für die synthetische Prüfung von Hochspannungs-Leistungsschaltern zu schaffen, welcher vergleichsweise einfach, auf kleinem Raum und kostengünstig aufgebaut werden kann.

Der Vorteil der Erfindung ist darin zu sehen, dass sie mit einfachen, handelsüblichen Mitteln realisiert werden kann. Für den Aufbau des Prüfkreises wird vergleichsweise wenig Platz benötigt, so dass, bei vorgegebenen Raumverhältnissen, eine höhere Prüfleistung erreicht werden kann. Ferner ist der Prüfkreis wegen seines vergleichsweise geringen Energieinhaltes bezüglich gefährlicher Ueberspannungen unkritisch. Besonders vorteilhaft wirkt es sich aus, dass nur in sehr geringem Umfang Wartungsarbeiten nötig sind.

Die weiteren Ausgestaltungen der Erfindung sind Gegenstände der abhängigen Ansprüche.

Nachfolgend wird die Erfindung anhand von Zeichnungen näher erläutert.

Es zeigt:

Fig. 1 eine erste Ausführungsform des erfindungsgemässen Prüfkreises,

Fig. 2 eine stark vereinfachte und nicht massstäbliche Skizze der Strom- und Spannungsverläufe bei einer Leistungsabschaltung mit dem Prüfkreis gemäss Fig. 1,

Fig. 3 einen vergrösserten Ausschnitt aus der Skizze gemäss Fig. 2,

Fig. 4 eine erste Modifikation des Prüfkreises,

Fig. 5 eine zweite Modifikation des Prüfkreises,

Fig. 6 eine dritte Modifikation des Prüfkreises und

Fig. 7 eine vierte Modifikation des Prüfkreises.

Bei allen Figuren sind gleich wirkende Elemente mit gleichen Bezugszeichen versehen.

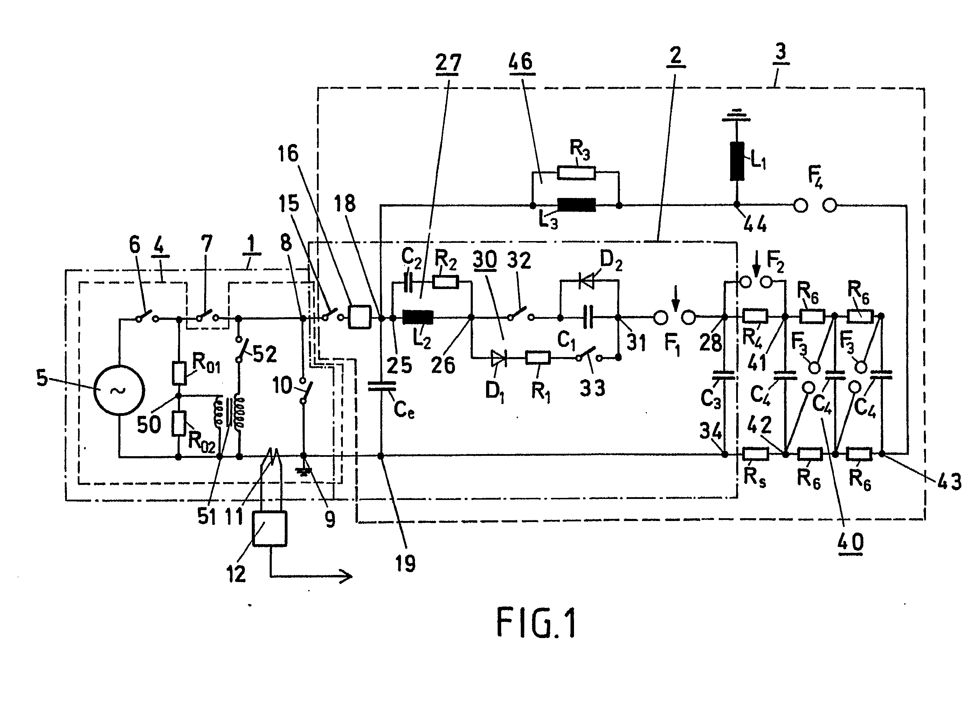

In der Fig. 1 ist der aus einem Hochstromkreis 1 und drei Hochspannungskreisen 2, 3, 4 bestehende Prüfkreis dargestellt. Der Hochstromkreis 1 besteht aus einer Spannungsquelle 5, die in Reihe geschaltet ist mit einem Draufschalter 6, einem Hilfsschalter 7 und einem zwischen Abgangsklemmen 8, 9 des Hochstromkreises 1 geschalteten Hochspannungs-Leistungsschalter als Prüfschalter 10. Die Abgangsklemme 9 ist geerdet. Ueber einen als Stromwandler ausgebildeten Sensor 11 werden bei geschlossenem Hochstromkreis 1 stromproportionale Signale abgegriffen und in eine elektronische Steuereinheit 12 zur weiteren Verarbeitung geleitet.

Die Abgangsklemme 8, welche gleichzeitig auch eine erste Abgangsklemme des Hochspannungskreises 2 ist, ist über einen Hilfsschalter 15 und eine zu diesem in Reihe geschaltete Anordnung 16 mit einer Klemme 18 verbunden. Die Anordnung 16 kann im Falle von Abstandskurzschlussprüfungen eine künstliche Leitung, bzw. im Falle von Klemmenkurzschlussprüfungen ein Netzwerk sein, welches erlaubt, den ersten Teil des Anstiegs der wiederkehrenden Spannung über dem Prüfschalter 10 je nach Erfordernis einzustellen. Zwischen die Klemme 18 und eine, mit der Abgangsklemme 9 verbundene Klemme 19 ist ein Kondensator $C_e$ parallel zum Prüfschalter 10 geschaltet. Die Abgangsklemme 9 ist gleichzeitig auch die zweite Abgangsklemme des Hochspannungskreises 2. Die Klemme 18 ist mit einer Klemme 25 leitend verbunden. Zwischen die Klemme 25 und eine Klemme 26 ist ein Einstellglied 27 zwischengeschaltet, welches aus einer Reihenschaltung eines Kondensators $C_2$ mit einem ohmschen Widerstand $R_2$ besteht, zu welcher eine Induktivität $L_2$ parallelgeschaltet ist.

Zwischen der Klemme 26 und einer Klemme 28 liegt eine triggerbare Schaltstelle 30. Diese triggerbare Schaltstelle 30 besteht aus einer triggerbaren Funkenstrecke $F_1$ als Einschaltgerät, welche zwischen der Klemme 28 und einer Klemme 31 angeordnet ist, und einer zwischen den Klemmen 31 und 26 liegenden Schaltungsanordnung. Ein erster Zweig dieser Schaltungsanordnung enthält eine Reihenschaltung eines aus mindestens einer Vakuumschaltröhre bestehenden Schaltelementes 32 mit einem von einer nicht dargestellten Gleichspannungsquelle her aufladbaren Kodensator $C_1$, der als Niederspannunngskondensator ausgebildet ist, zu welchem eine Diode $D_2$ parallelgeschaltet ist. Diese Diode $D_2$ ist für Ströme, welche von der Klemme 31 her eingespeist werden, durchlässig. Ein zweiter, zum ersten paralleler Zweig der Schaltungsanordnung enthält eine Reihenschaltung einer Diode $D_1$, eines ohmschen Widerstandes $R_1$ und einer Unterbrechungsstelle 33, wobei die Diode $D_1$ für Ströme durchlässig ist, welche von der Klemme 26 herr eingespeist werden. Zwischen die Klemme 28 und eine Klemme 34, welche mit der Klemme 19 leitend verbunden ist, is die Kondensatorbatterie $C_3$ geschaltet.

Die Kondensatorbatterie $C_3$ dient als mit Hochspannung aufladbarer Energiespeicher für den Hochspannungskreis 2, sie ist jedoch gleichzeitig ein Teil des Energiespeichers für den Hochspannungskreis 3. Der Energiespeicher für den Hochspannungskreis 3 ist als Marx'scher Stoossgenerator 40 ausgebildet, dessen erste Stufe die Kondensatorbatterie $C_3$ bildet. An die Klemme 28 kann ein nicht dargestellte Aufladeeinrichtung angeschlossen werden. Zwischen der Klemme 28 und einer Klemme 41 ist ein Ladewiderstand $R_4$ angeschlossen sowie eine triggerbare Funkenstrecke $F_2$. Zwischen der Klemme 34 und einer Klemme 42 liegt ein weiterer Ladewiderstand $R_5$. Zwischen den Klemmen 41 und 42 ist ein Kondensator $C_4$ angeschlossen, welcher eine zweite Stufe des Marx'schen Stossgenerators 40 bildet. Von den Klemmen 41 und 42 ausgehend schliessen sich zwei weitere Stufen an, damit weist der dargestellte Marx'sche Stossgenerator 40 insgesamt vier Stufen auf, welche auf bekannte Weise mittels der zugehörigen Funkenstrecken $F_2$ und $F_3$ in Serie schaltbar sind, so dass an einer Klemme 43 die vierfache Ladespannung verfügbar ist. Dieser Stossgenerator kann leicht durch Hinzufügung oder Weglassung von Stufen verändert werden, um ihn den jeweilig erforderlichen Prüfspannungen anzupassen. Die Ladewiderstände $R_4$, $R_5$ und auch $R_6$ sind extrem hochohmig, sie weisen alle den gleichen Widerstandswert im Bereich von 0,1 bis 10 Megaohm auf.

Von der Klemme 43 führt eine leitende Verbindung zu einer Funkenstrecke $F_4$ und von dort weiter zu einer Klemme 44. Von dieser Klemme 44 aus ist eine Induktivität $L_1$ gegen Ende geschaltet. Die Induktivität $L_1$ ist so bemessen, dass sie zusammen mit der Reihenschaltung der Kondensatoren des Marx'schen Stossgenerators 40 einen Schwingkreis bildet. Zwischen der Klemme 44 und der Klemme 18 liegt ein Einstellglied 46, welches aus der Parallelschaltung einer Induktivität $L_3$ mit einem ohmschen Widerstand $R_3$ besteht. Statt mit der Klemme 18 kann das Dämpfungsglied 46 auch mit der Klemme 26 verbunden werden. Ferner ist es möglich, den Hochspannungskreis 3 auch ohne die Funkenstrecke $F_4$ zu betreiben.

Im Hochspannungskreis 4 liegt die Spannungsquelle 5 mit einem an ihrem Ausgang angebrachten, aus den ohmschen Widerständen $R_{01}$, $R_{02}$ bestehenden Spannungsteiler, der als Wechselspannungsquelle für diesen Hochspannungskreis 4 dient. Der Spannungsteiler weist einen Mittelabgriff 50 auf, welcher mit der Unterspannungswicklung eines leistungsschwachen Transformators oder eines Spannungswandlers 51 verbunden ist. Die Oberspannungsseite dieses Spannungswandlers 51 ist über einen Schalter 52 mit der Abgangsklemme 8 verbunden. Anstelle des Schalters 52 ist auch eine durchgehende Verbindung möglich.

Zur Erläuterung der Wirkungsweise des Prüfkreises sei die Figur 1 näher betrachtet. Die Hilfsschalter 7 und 15, das Schaltelement 32 und der Prüfschalter 10 sind zunächst geschlossen, der Draufschalter 6 und die Unterbrechungsstelle 33 sind dagegen offen. Der Kondensator $C_1$, der eine Kapazität von ca. 2 bis 15 mF aufweist, wird mit Niederspannung aufgeladen auf eine Spannung im Bereich von 100 V bis einige 100 V. Die Kondensatorbatterie $C_3$ und die Kondensatoren $C_4$ werden über die Klemme 28 mit einer Spannung $U_L$ aufgeladen. Das Ladegerät für diese Aufladung kann für vergleichsweise niedrige Hochspannungswerte, in der Grössenordnung von beispielsweise 50 kV, ausgelegt sein. Die Kondensatorbatterie $C_3$ kann eine Kapazität von 2 bis 40 Mikrofarad aufweisen, die Kondensatoren $C_4$ eine solche von jeweils etwa 1,5 Mikrofarad. Der Kondensator $C_e$ liegt in der Regel im Bereich von 5 bis 40 Nanofarad. Es sind auch andere Kapazitätswerte möglich, jedoch muss der Kapazitätswert der in Reihe geschalteten Kondensatoren des Marx'schen Stossgenerators 40 stets um mindestens das Fünf- bis Zehnfache höher liegen als der des Kondensators $C_e$. Nach dem Aufladen werden die nicht dargestellten Ladequellen abgekoppelt, sie können auch, wenn hinreichend grosse Ladewiderstände in Serie mit der jeweiligen Ladequelle vorgesehen sind, in Verbindung mit dem Prüfkreis bleiben.

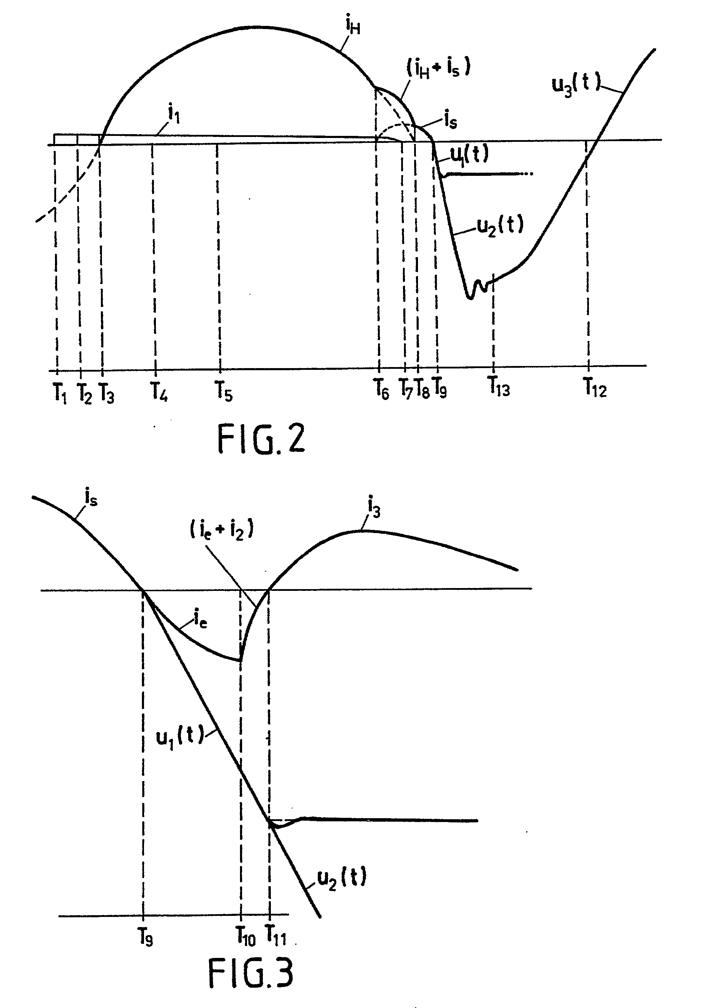

Für die weiteren Erläuterungen sei die Fig. 1 gemeinsam mit Fig. 2 betrachtet. Der Draufschalter 6 wird, entsprechend der für den Prüfschalter 10 qewünschten Stromflussdauer in einem Zeitpunkt $T_3$ geschlossen. Danach liefert die Spannungsquelle 5 den gewünschten Prüfstrom $i_H$ in den Hochstromkreis 1. Der Prüfschalter 10 wird in einem Zeitpunkt $T_4$ geöffnet, entsprechend der gewünschten Lichtbogendauer im Prüfschalter 10. In einem Zeitpunkt $T_5$ wird der Hilfsschalter 7 geöffnet. Unabhängig von diesen Schaltvorgängen wird in einem Zeitpunkt T1 die Unterbrechungsstelle 33 geschlossen,

und der Kondensator $C_1$ speist einen Entladestrom $i_1$ über das geschlossene Schaltelement 32, die Diode $D_1$ und den Widerstand $R_1$, welcher diesen Entladestrom $i_1$ begrenzt. In einem Zeitpunkt $T_2$ öffnet sich das geschlossene Schaltelement 32, welches hier als mindestens eine Vakuumschaltröhre ausgebildet ist. Der Entladestrom $i_1$ fliesst jedoch weiterhin, über den in der Vakuumschaltröhre bestehenden Lichtbogen.

Der zeitliche Ablauf der gesamten Schaltvorgänge wird von der Steuereinheit 12, die vorab entsprechend eingestellt worden ist, gesteuert. Vom Sensor 11, einem Stromwandler, gelangen ferner zum Prüfstrom $i_H$ proportionale Signale in die Steuereinheit 12 und werden dort in zeitgenaue Triggersignale umgesetzt. Eines dieser Triggersignale wirkt in einem Zeitpunkt $T_6$ auf die Funkenstrecke $F_1$ ein, deren Ansprechspannung etwas über der Spannung $U_L$ an der Kondensatorbatterie $C_3$ liegt, und bringt sie im Zeitpunkt $T_6$ zum Durchzünden. Die Schaltstelle 30 ist, dank dem noch bestehenden Lichtbogen im Schaltelement 32 leitend für einen von der Kondensatorbatterie $C_3$ gespeisten Schwingstrom $i_s$. Dieser Schwingstrom $i_s$ entlädt zunächst den Kondensator $C_1$ und der Entladestrom $i_1$ wird dadurch in einem Zeitpunkt $T_7$ Null. Danach kommutiert der Schwingstrom $i_s$ auf die Strombahn durch die Diode $D_2$. Der Schwingstrom $i_s$ fliesst somit im Hochspannungskreis 2 durch die Schaltstelle 30, durch das Einstellglied 27, durch die Anordnung 16 und den Hilfsschalter 15 sowie den Prüfschalter 10. Im Zeitbereich zwischen $T_6$ und einem Zeitpunkt $T_8$ überlagert sich der Schwingstrom $i_s$ dem Prüfstrom $i_H$ zu einem Strom $(i_s + i_H)$. Im Zeitpunkt $T_8$ geht der Prüfstrom $i_H$ durch Null und der Hilfsschalter 7 löscht in diesem Moment. Durch den Prüfschalter 10 fliesst vom Zeitpunkt $T_8$ bis zu einem Zeitpunkt $T_9$ nur noch der Schwingstrom $i_s$, dessen Steilheit unmittelbar vor dem Stromnulldurchgang genau der Sollsteilheit des Prüfstromes $i_H$ in dessen Nulldurchgang entspricht. Der Prüfschalter 10 löscht in einem Zeitpunkt $T_9$ den Schwingstrom $i_s$ in seinem Nulldurchgang, gleichzeitig löscht auch das Schaltelement 32. Der Schwingstrom $i_s$ fliesst demnach nur während einer Halbwelle, er lädt in dieser Zeit, wenn Leitungsverluste als vernachlässigbar betrachtet werden, die Kondensatorbatterie $C_3$ um auf die negative Gleichspannung $-U_L$. Der Kondensator $C_2$ mit einem Kapazitätswert im Bereich von 0,05 bis 2 Mikrofarad ist im Vergleich zur Kondensatorbatterie $C_3$ klein. Er wird ebenfalls auf die Gleichspannung $-U_L$ aufgeladen. Der geladene Kondensator $C_2$ bildet dann mit dem Widerstand $R_2$ und der Induktivität $L_2$ einen Schwingkreis, der ausschwingt.

Zusätzlich zu den bisher betrachteten Figuren sei noch die Figur 3 zur Erläuterung beigezogen. Nach dem Erlöschen des Schwingstroms $i_s$ baut sich eine wiederkehrende Spannung $u_1(t)$ über dem Prüfschalter 10 auf, indem der Kondensator $C_e$ durch einen Ladestrom $i_e$ aufgeladen wird, wobei der Verlauf des transienten Anteils von $u_1(t)$ durch den durch das Einstellglied 27 gebildeten ausschwingenden Schwingkreis bestimmt wird. Der Ladestrom $i_e$ wird durch die Kondensatorbatterie $C_3$ gespeist und fliesst über den Kondensator $C_e$, das Einstellglied 27, die Diode $D_1$, den Widerstand $R_1$, die Unterbrechungsstelle 33 und die Funkenstrecke $F_1$. Sollte im Prüfschalter 10 noch eine gewisse Restleitfähigkeit der Abschaltstrecke bestehen, so könnte dort ein thermischer Nachstrom, welcher durch die leistungsstarke Kondensatorbatterie $C_3$ gespeist würde, fliessen. Der Widerstand $R_1$, dessen Widerstandswert im Bereich von 1 bis 10 Ohm liegt, ist zu klein, um den Ladestrom $i_e$ zu beeinflussen.

Die wiederkehrende Spannung $u_1(t)$ steigt im Hochspannungskreis 2 weiter an bis zur augenblicklichen maximalen Ladespannung der Kondensatorbatterie $C_3$. Kurz vor dem Erreichen dieser maximalen Ladespannung, wird in einem Zeitpunkt $T_{10}$ die Funkenstrecke $F_2$, welche auf eine Ansprechspannung etwas grösser als die doppelte Gleichspannung $U_L$, eingestellt ist, von der Steuereinheit 12 her mit einem Triggersignal beaufschlagt und zum Durchzünden gebracht. Im gleichen Augenblick zünden auch die Funkenstrecken $F_3$ des Marx'schen Stossgenerators 40 und die Funkenstrecke $F_4$ durch, welche auf eine Ansprechspannung etwas höher als die Gleichspannung $U_L$ eingestellt sind. Die geladenen Kondensatoren $C_4$ und die Kondensatorbatterie $C_3$ sind jetzt in Reihe geschaltet und bilden den Energiespeicher für den Hochspannungskreis 3. Allerdings leistet der Hochspannungskreis 3 nicht sofort einen Beitrag zum weiteren Aufbau der wiederkehrenden Spannung über dem Prüfschalter 10. Vom Zeitpunkt $T_{10}$ bis zu einem Zeitpunkt $T_{11}$, grössenordnungsmässig etwa während 1 bis 2 Mikrosekunden, fliesst ein Schwingstrom $i_2$, gespeist durch den Energiespeicher für den Hochspannungskreis 3, durch die Funkenstrecke $F_1$, die Unterbrechungsstelle 33, den Widerstand $R_1$, die Diode $D_1$, das Einstellglied 27, das Einstellglied 46 und die Funkenstrecke 4. Der Schwingstrom $i_2$ fliesst durch die Diode $D_1$, da zunächst die Klemme 18 positiver ist als die Klemme 28. Der Schwingstrom $i_2$ ist entgegengesetzt zum Ladestrom $i_e$ gerichtet. Die beiden Ströme überlagern sich zu einem Strom $(i_e + i_2)$, wodurch im Zeitpunkt $T_{11}$ ein Stromnulldurchgang erfolgt und die Diode $D_2$ zu sperren beginnt. Die Schaltstelle 30 ist damit unterbrochen und gleich zeitig ist damit die Umschaltung vom Hochspannungskreis 2 zum Hochspannungskreis 3 ohne Unterbrechung der Spannungsbeaufschlagung des Prüfschalters 10 erfolgt.

Der Hochspannungskreis 3 liefert eine wiederkehrende Spannung $u_2(t)$, deren Verlauf bestimmt ist durch das Zusammenwirken des Kondensators $C_e$ mit dem Einstellglied 46, und die der Spannung $u_1(t)$ überlagert ist. Gleichzeitig mit der Initialisierung des Hochspannungskreises 3 beginnt der Energiespeicher für den Hochspannungskreis 3 zusammen mit der Induktivität $L_1$ zu schwingen und ein Schwingstrom $i_3$ beginnt zu fliessen. Dieser Schwingungsvorgang simuliert die erste Halbwelle der netzfrequenten wiederkehrenden Spannung über dem Prüfschalter 10. In einem Zeitpunkt $T_{12}$ wird der Hilfsschalter 15 geöffnet, welcher den Hochspannungskreis 3 vom Prüfschalter 10 trennt.

An die Qualität der Induktivität $L_1$ werden keine grossen Anforderungen gestellt, sie kann einen hohen ohmschen Verlustfaktor aufweisen, da sie nur während einer Stromhalbwelle für den Prüfkreis benutzt wird. Demzufolge kann sie sehr preiswert ausgeführt werden. Es ist aber auch möglich die Induktivität $L_1$ zu eliminieren, wenn der Hochspannungskreis 3 statt im Zeitpunkt $T_{12}$ in einem früheren, kurz nach dem Scheitel der wiederkehrenden Spannung $u_2(t)$ gelegenen Zeitpunkt $T_{13}$ abgetrennt wird, allerdings sind in diesem Fall die Anforderungen an den Hilfsschalter 15 höher.

Ferner ist es möglich den Hochspannungskreis 3 dahingehend zu modifizieren, dass nach dem Einstellglied 46 keine direkte Verbindung zur Klemme 18 geschaltet wird, sondern dass über die Klemme 26 und das Einstellglied 27 eine Verbindung zur Klemme 18 hergestellt wird. Mit dieser Modifikation lässt sich ein besser geglätteter Verlauf der wiederkehrenden Spannung $u_2(t)$ erreichen. Vor dem Abtrennen des Hochspannungskreises 3 wird der Hochspannungskreis 4 auf den Prüfschalter 10 draufgeschaltet. Der Hochspannungskreis 4 ist leistungsschwach, da er nur eine netzfrequente Spannung $u_3(t)$ für den Prüfschalter 10 liefern muss. Die netzfrequente Spannung $u_3(t)$ wird von der Spannungsquelle 5 geliefert, welche bis zum Zeitpunkt $T_8$ den Prüfstrom $i_H$ geliefert hat, dadurch ist sichergestellt, dass die netzfrequente Spannung $u_3(t)$ phasenrichtig und ohne Unterbrechung zugeschaltet wird. Diese Spannungsbelastung des Prüfschalters 10 kann nun beliebig lange aufrechterhalten werden und dann durch einen zwischen Spannungsquelle 5 und Draufschalter 6 liegenden, nicht dargestellten Leistungsschalter abgeschaltet werden.

Als weitere Schaltungsvariante des Prüfkreises ist es auch möglich, den Hilfsschalter 15 anstelle der Anordnung 16 zu plazieren und die Anordnung 16 anstelle des Hilfsschalters sowie die eine Seite des Kondensators $C_e$ nicht mit der Klemme 18 zu verbinden, sondern mit einem Leiter, welcher dann die Anordnung 16 und den Hilfsschalter verbindet. Ferner könnte an diesen Leiter auch die Oberspannungsseite des Spannungswandlers 51 angeschlossen werden. Bei dieser Schaltungsvariante kann der Hochspannungskreis 3 etwas leistungsschwächer dimensioniert werden, da er die Anordnung 16 nicht mehr enthält.

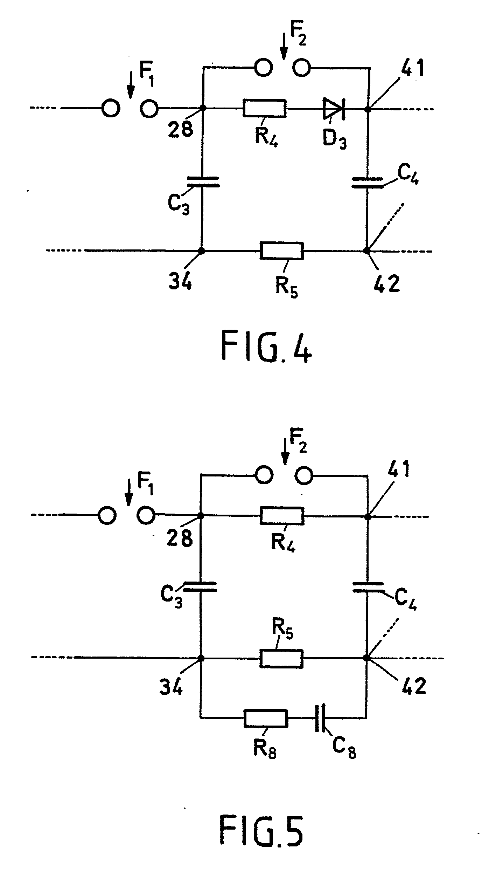

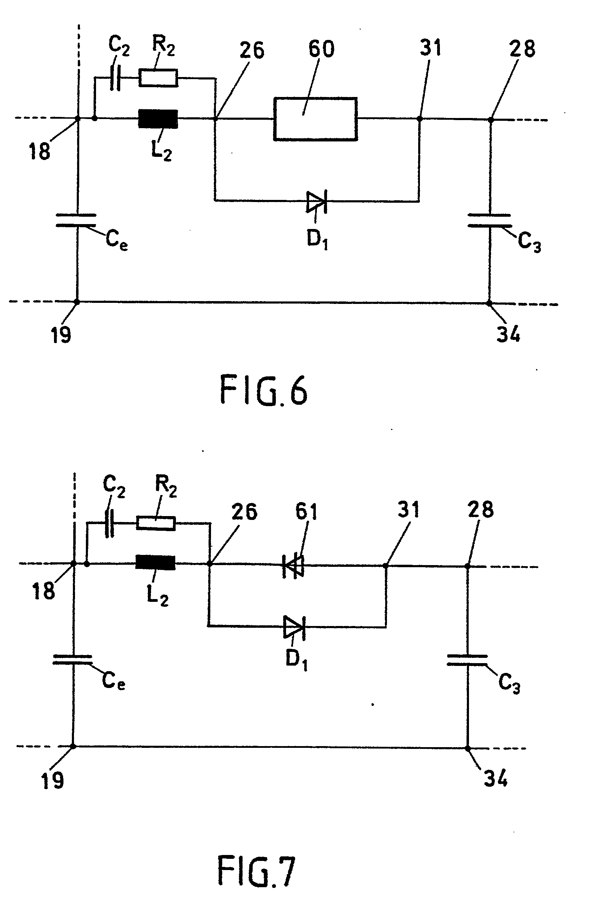

Weiterhin kann in den Prüfkreis, gemäss Fig. 1, wie aus Fig. 4 ersichtlich, eine Diode $D_3$ zwischen den Ladewiderstand $R_4$ und die Klemme 41 geschaltet werden. Die Diode $D_3$ lässt Ströme durch in Richtung auf die Klemme 41 zu. Dadurch wird verhindert, dass sich das Potential der Klemme 41 im Zeitraum vom Zeitpunkt $T_6$ bis zum Zeitpunkt $T_{10}$, also vom Durchzünden der Funkenstrecke $F_1$ bis zum Durchzünden der Funkenstrecke $F_2$ zu stark verändert. Der gleiche Effekt kann auch erreicht werden, wenn parallel zum Ladewiderstand $R_5$, wie aus Fig. 5 ersichtlich, ein sinnvoll dimensioniertes RC-Glied aus einem Widerstand $R_8$ und einem Kondensator $C_8$ geschaltet wird.

Aus Fig. 6 ist eine Modifikation des Prüfkreises nach Fig. 1 ersichtlich, welche die Funkenstrecke $F_1$, den Kondensator $C_1$ samt Ladeeinrichtung, die Diode $D_2$, den Widerstand $R_2$ und die Unterbrechungsstelle 33 entbehrlich macht. Zwischen die Klemmen 26 und 31 ist mindestens eine triggerbare Vakuumstrecke 60 (triggered vacuum gap) zwischengeschaltet, zu der die Diode $D_1$ parallel liegt. Das von der Steuereinheit 12 herrührende Triggersignal macht die triggerbare Vakuumstrecke 60 zeitgenau leitfähig, so dass der Schwingstrom $i_s$ fliessen kann. Der weitere Verlauf der Leistungsabschaltung entspricht dem bereits früher geschilderten Ablauf.

Aus Fig. 7 ist eine weitere Modifikation des Prüfkreises nach Fig. 1 ersichtlich, welche ähnlich wie die Schaltung nach Fig. 6 aufgebaut ist, und auch ähnlich wirkt, nur dass anstelle der triggerbaren Vakuumstrecke mindestens ein triggerbarer Thyristor 61 vorgesehen ist, auf welchen das von der Steuereinheit 12 herrührende Triggersignal einwirkt und ihn zeitgenau leitfähig macht.

## Patentansprüche

1. Prüfkreis für die synthetische Prüfung des Ausschaltvermögens von Hochspannungs-Leistungsschaltern mit einem einen Prüfschalter (10) und einen Hilfsschalter (7) enthaltenden Hochstromkreis (1), und mit mindestens zwei Hochspannungskreisen (2, 4), von denen ein erster (2) in Reihe geschaltet mindestens einen ersten Energiespeicher und eine Schaltstelle (30) aufweist und als parallel zum Prüfschalter (10) schaltbarer Schwingkreis ausgebildet ist, und ein zweiter (4) eine den Prüfschalter (10) mit Wechselspannung beaufschlagende Wechselspannungsquelle aufweist, dadurch gekennzeichnet,
- dass die Schaltstelle (30) mindestens zwei parallel zueinander angeordnete Schaltelemente aufweist, von denen ein erstes während einer ersten Halbwelle des im ersten Hochspannungskreis gebildeten Schwingstromes ($i_s$) sperrt und ein zweites (32) den Schwingstrom ($i_s$) verzögerungsfrei im ersten Stromnulldurchgang unterbricht.

2. Prüfkreis nach Anspruch 1, dadurch gekennzeichnet,
- dass das erste Schaltelement ein erstes elektrisches Ventil enthält,
- dass das zweite Schaltelement (32) mit einem ersten Kondensator ($C_1$) in Reihe geschaltet ist, wobei parallel zum ersten Kondensator ($C_1$) ein zweites elektrisches Ventil vorgesehen ist, welches entgegengesetzt zum ersten elektrischen Ventil gepolt ist, und
- dass die Schaltstelle (30) in Reihe zu den beiden Schaltelementen ein Einschaltgerät aufweist.

3. Prüfkreis nach Anspruch 2, dadurch gekennzeichnet,
- dass das Einschaltgerät als eine erste triggerbare Funkenstrecke ($F_1$) ausgebildet ist,
- dass das zweite Schaltelement (32) mindestens eine Vakuumschaltröhre enthält,
- dass der erste Kondensator ($C_1$) als Niederspannungskondensator ausgebildet ist, und

- dass das erste und das zweite elektrische Ventil jeweils mindestens eine Diode (D₁, D₂) aufweisen.

4. Prüfkreis nach Anspruch 1, dadurch gekennzeichnet,
- dass das erste Schaltelement als elektrisches Ventil ausgebildet ist, und
- dass das zweite Schaltelement mindestens eine triggerbare Vakuumstrecke (60) aufweist.

5. Prüfkreis nach Anspruch 1, dadurch gekennzeichnet, - dass das erste Schaltelement als elektrisches Ventil ausgebildet ist, und
- dass das zweite Schaltelement mindestens einen triggerbaren Thyristor (61) aufweist.

6. Prüfkreis nach einem der Ansprüche 4 oder 5, dadurch gekennzeichnet,
- dass das elektrische Ventil mindestens eine Diode (D₁) enthält.

7. Prüfkreis nach einem der Ansprüche 1 bis 6, dadurch gekennzeichnet,
- dass ein nach dem Unterbrechen des ersten Hochspannungskreises (2) parallel zum Prüfschalter (10) schaltbarer dritter Hochspannungskreis (3) mit einem zweiten Energiespeicher vorgesehen ist.

8. Prüfkreis nach Anspruch 7, dadurch gekennzeichnet,
- dass der erste Energiespeicher als Kondensatorbatterie (C₃) ausgebildet ist und eine erste Stufe eines Marx'schen Stossgenerators (40) bildet, welcher als zweiter Energiespeicher des dritten Hochspannungskreises (3) vorgesehen ist.

9. Prüfkreis nach Anspruch 8, dadurch gekennzeichnet,
- dass der Marx'sche Stossgenerator (40) mit einer auf dessen Kapazitätswert abgestimmten, einseitig geerdeten Induktivität (L₁), mit einem Einstellglied (46) und mindestens einem zum Prüfschalter (10) parallelgeschalteten Kondensator (Cₑ) über eine zweite Funkenstrecke (F₄) zum dritten Hochspannungskreis (3) zusammenschaltbar ist.

10. Prüfkreis nach Anspruch 9, dadurch gekennzeichnet,
- dass der Kapazitätswert des Marx'schen Stossgenerators (40) mindestens um das Fünf- bis Zehnfache höher liegt als der des zum Prüfschalter (10) parallelgeschalteten Kondensators (Cₑ).

11. Prüfkreis nach einem der Ansprüche 1 bis 10, dadurch gekennzeichnet,
- dass die Wechselspannungsquelle als Spannungswandler (51) ausgebildet ist, dessen Unterspannungswicklung von der Spannungsquelle (5) über einen Spannungsteiler (R₀₁, R₀₂) gespeist wird, und dessen Oberspannungsseite mit dem Prüfschalter (10) verbunden ist.

## Claims

1. Test circuit for the synthetic testing of the breaking capacity of high-voltage circuit-breakers, having a high-current circuit (1) containing a test switch (10) and an auxiliary switch (7), and having at least two high-voltage circuits (2, 4), of which a first (2) has at least one first energy store and a switching point (30) connected in series and is designed as switchable resonant circuit parallel to the test switch (10), and a second (4) has an AC voltage source applying AC voltage to the test switch (10), characterized in that the switching point (30) has at least two switching elements arranged parallel to one another, of which a first blocks during a first half-wave of the oscillating current (iₛ) formed in the first high-voltage circuit and a second (32) interrupts the oscillating current (iₛ) without delay in the first zero crossing of the current wave.

2. Test circuit according to claim 1, characterized in that
- the first switching element contains a first electric valve,
- the second switching element (32) is connected in series with a first capacitor (C₁), a second electric valve of opposite polarisation to the first electric valve being provided parallel to the first capacitor (C₁), and
- the switching point (30) has a making device in series with the two switching elements.

3. Test circuit according to claim 2, characterized in that
- the making device is designed as a first triggerable spark gap (F₁),
- the second switching element (32) contains at least one vacuum interrupter,
- the first capacitor (C₁) is designed as a low-voltage capacitor, and
- the first and the second electric valve have in each case at least one diode (D₁, D₂).

4. Test circuit according to claim 1, characterized in that
- the first switching element is designed as an electric valve, and
- the second switching element has at least one triggerable vacuum gap (60).

5. Test circuit according to claim 1, characterized in that
- the first switching element is designed as an electric valve, and
- the second switching element has at least one triggerable thyristor (61).

6. Test circuit according to one of claims 4 or 5, characterized in that the electric valve contains at least one diode (D₁).

7. Test circuit according to one of claims 1 to 6, characterized in that a third high-voltage circuit (3) switchable parallel to the test switch (10) after the interruption of the first high-voltage circuit (2) is provided with a second energy store.

8. Test circuit according to claim 7, characterized in that the first energy store is designed as a capacitor bank (C₃) and forms a first stage of a Marx impulse generator (40) which is provided as second energy store of the third high-voltage circuit (3).

9. Test circuit according to claim 8, characterized in that the Marx impulse generator (40) can be interconnected with an inductor (L₁) which is matched to its capacitance and is earthed at one side, with an adjusting element (46) and at least one capacitor (Cₑ) connected in parallel with the test switch (10), via a second spark gap (F₄) to the third high-voltage circuit (3).

10. Test circuit according to claim 9, characterized in that the capacitance of the Marx impulse generator (40) is at least five to ten times higher than that of the capacitor ($C_e$) connected in parallel with the test switch (10).

11. Test circuit according to one of claims 1 to 10, characterized in that the AC voltage source is designed as voltage transformer (51), the low-voltage winding of which is fed by the voltage source (5) via a voltage divider ($R_{01}$, $R_{02}$), and the high-voltage side of which is connected to the test switch (10).

## Revendications

1. Circuit d'essai pour l'essai synthétique du pouvoir de coupure de disjoncteurs de puissance à haute tension comportant un circuit à courant fort (1) comprenant un disjoncteur d'essai (10) et un disjoncteur auxiliaire (7), et au moins deux circuits à haute tension (2, 4), dont un premier (2) présente, montés en série, au moins un premier accumulateur d'énergie et un point de commutation (30) et a la forme d'un circuit oscillant commutable en parallèle avec le disjoncteur d'essai (10), et un deuxième (4) présente une source de tension alternative alimentant le disjoncteur d'essai (10) au moyen d'une tension alternative, caractérisé en ce que
- le point de commutation (30) comporte au moins deux interrupteurs disposés en parallèle, dont un premier est bloquant, durant une première demionde du courant oscillant ($i_s$) formé dans le premier circuit à haute tension, tandis qu'un deuxième (32) interrompt le courant oscillant ($i_s$) sans retard lors du premier passage par zéro du courant.

2. Circuit d'essai suivant la revendication 1, caractérisé en ce que
- le premier interrupteur comprend une première valve électrique,
- le deuxième interrupteur (32) est connecté en série avec un premier condensateur ($C_1$), une deuxième valve électrique étant prévue en parallèle avec le premier condensateur ($C_1$) et étant polarisée en opposition à la première valve électrique, et
- le point de commutation (30) comporte un dispositif d'enclenchement en série avec les deux interrupteurs.

3. Circuit d'essai suivant la revendication 2, caractérisé en ce que
- le dispositif enclencheur a la forme d'un premier éclateur ($F_1$) à déclenchement,
- le deuxième interrupteur (32) comprend au moins un interrupteur à vide,
- le premier condensateur ($C_1$) a la forme d'un condensateur à basse tension, et
- la première et la deuxième valve électrique comprennent chacune au moins une diode ($D_1$, $D_2$).

4. Circuit d'essai suivant la revendication 1, caractérisé en ce que
- le premier interrupteur a la forme d'une valve électrique, et
- le deuxième interrupteur comporte au moins une coupure à vide (60) à déclenchement.

5. Circuit d'essai suivant la revendication 1, caractérisé en ce que

- le premier interrupteur a la forme d'une valve électrique, et
- le deuxième interrupteur comporte au moins un thyristor à déclenchement (61).

6. Circuit d'essai suivant la revendication 4 ou 5, caractérisé en ce que
- la valve électrique comprend au moins une diode ($D_1$).

7. Circuit d'essai suivant l'une quelconque des revendications 1 à 6, caractérisé en ce que
- un troisième circuit à haute tension (3), qui peut être connecté en parallèle au disjoncteur d'essai (10) après l'ouverture du premier circuit à haute tension (2), est pourvu d'un deuxième accumulateur d'énergie.

8. Circuit d'essai suivant la revendication 7, caractérisé en ce que
- le premier accumulateur d'énergie a la forme d'une batterie de condensateurs ($C_3$) et forme un premier étage d'un générateur de choc de Marx (40), qui est prévu à titre de deuxième accumulateur d'énergie du troisième circuit à haute tension (3).

9. Circuit d'essai suivant la revendication 8, caractérisé en ce que
- le générateur de choc de Marx (40) avec une inductance ($L_1$) mise à la masse d'un côté et accordée sur sa valeur de capacité, avec un élément de réglage (46) et au moins un condensateur ($C_e$) connecté en parallèle au disjoncteur d'essai (10) peut être connecté au troisième circuit à haute tension (3), par l'intermédiaire d'un deuxième éclateur ($F_4$).

10. Circuit d'essai suivant la revendication 9, caractérisé en ce que
- la valeur de capacité du générateur de choc de Marx (40) vaut au moins cinq à dix fois celle du condensateur ($C_e$) connecté en parallèle au disjoncteur d'essai (10).

11. Circuit d'essai suivant l'une quelconque des revendications 1 à 10, caractérisé en ce que
- la source de tension alternative a la forme d'un transformateur de tension (51), dont l'enroulement basse tension est alimenté par la source de tension (5) par l'intermédiaire d'un diviseur de tension ($R_{01}$, $R_{02}$) et dont le côté haute tension supérieur est relié au disjoncteur d'essai (10).

FIG.1

FIG.2

FIG.3

FIG.4

FIG.5

FIG.6

FIG.7